Europäisches Patentamt

European Patent Office

Office européen des brevets

(11) Publication number: **0 040 251 B1**

# EUROPEAN PATENT SPECIFICATION

(45) Date of publication of patent specification: **06.05.87**

(21) Application number: **80902128.0**

(22) Date of filing: **06.11.80**

(86) International application number:
**PCT/JP80/00276**

(87) International publication number:
**WO 81/01484 28.05.81 Gazette 81/13**

(51) Int. Cl.⁴: **H 01 L 29/78, H 01 L 27/10, G 11 C 11/40**

(54) SEMICONDUCTOR MEMORY DEVICE.

(30) Priority: **12.11.79 JP 146167/79**

(43) Date of publication of application:
**25.11.81 Bulletin 81/47**

(45) Publication of the grant of the patent:
**06.05.87 Bulletin 87/19**

(84) Designated Contracting States:
**DE FR GB**

(56) References cited:
**FR-A-2 392 468**
**JP-A-48 013 042**
**JP-A-48 024 679**
**JP-A-50 002 872**

**IBM TECHNICAL DISCLOSURE BULLETIN, vol. 14, no. 12, May 1972, page 3721, Armonk, New York, US; L.M. TERMAN: "Floating avalanche-injection metal-oxide semiconductor device with low-write voltage"**

(73) Proprietor: **FUJITSU LIMITED**
**1015, Kamikodanaka Nakahara-ku**
**Kawasaki-shi Kanagawa 211 (JP)**

(72) Inventor: **MAEDA, Koh-ichi**
**Minoriso, 2103 Hiyoshihoncho, Kohoku-ku**
**Yokohama-shi Kanagawa 223 (JP)**

(74) Representative: **Muir, Ian R. et al**
**HASELTINE LAKE & CO. Hazlitt House 28**
**Southampton Buildings Chancery Lane**
**London WC2A 1AT (GB)**

(56) References cited:

**PATENTS ABSTRACTS OF JAPAN, vol. 2, no. 121, 12th October 1978, page 7073 E 78; & JP - A - 53 87 185 (OKI DENKI KOGYO K.K.) 01-08-1978**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a semiconductor memory device composed of double gate type field effect transistors having a control gate and a floating gate for accumulating charges. Moreover, it relates to a semiconductor memory device which assures high charge injection efficiency and also high read-out efficiency.

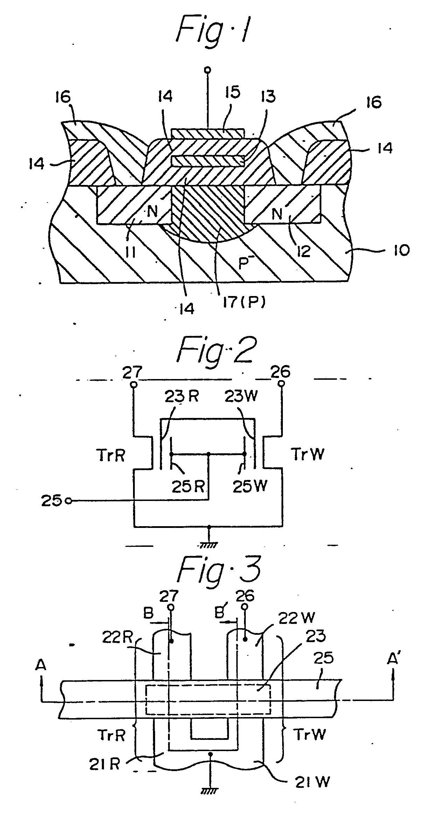

Some nonvolatile semiconductor memory devices use double gate type field effect transistors as the memory elements. Figure 1 shows the sectional view of a conventional double gate type field effect transistor. The structure and operation principle of a transistor of this type are disclosed in the U.S. Patent No. 3,984,822.

The transistor shown in Fig. 1 comprises, on a silicon semiconductor substrate 10 of a first conductivity type (P type), a source region 11 of the opposite conductivity type (N type ), a drain region 12, an electrically floated floating gate 13 and a control gate 15. The reference numeral 14 is the insulating layer (silicon oxide), while 16 is the lead-out electrode connected to the source 11 and drain 12. 17 is the high concentration region of the first conductivity type (P type).

The operation of this transistor as a memory element is explained hereunder.

(a) Injection of charge into the floating gate as the writ operation:

First, the substrate 10 and source region 11 are set to the same potential (ground potential), and a positive voltage of about 15V, for example, is applied to the drain region 12 while a positive voltage of about 20V (write voltage), for example, is applied to the control gate 15. In this condition, the transistor is fully saturated, and the channel between the source region 11 and drain region 12 is in the pinch-off condition and the channel carrier is sufficiently accelerated by a high electrical field in the depletion layer between the pinch-off point and the drain region 12, causing impact ionization. As a result, the avalanche phenomenon of electrons occurs. In this condition, a large amount of carrier (hot carrier) having a high energy exists in the depletion layer between the pinch-off point and the drain region 12. The hot electrons having energy higher than the energy barrier between the substrate 10 and insulating layer 14 move in the insulating layer 14 due to the field between the control gate 15 and substrate 10 and are then injected into the floating gate 13.

When the substrate 10 is N type and both source region 11 and drain region 12 are P type, the direction of the field is reversed from the abovementioned operation and a hole is injected into the floating gate 13. When once a charge is injected into the floating gate 13, such charge is accumulated semipermanently in the floating gate 13. A difference of conductivity of the channel of the transistor due to the presence of accumulated charge is used as the stored information.

(b) Read-out operation:

When electrons are accumulated in the floating gate 13, the threshold voltage becomes high. Therefore, an intermediate voltage (read-out voltage) between the threshold voltage when no electron is accumulated and that when electrons are accumulated is applied to the control gate 15. A transistor has a low conductivity or is not conductive when electrons are accumulated in the floating gate 13, and has a high conductivity when electrons are not accumulated.

(c) Erasure or removal of charges:

Charges can be removed by irradiating the transistor with ultra-violet radiation or other electromagnetic waves or radioactive radiation.

Explained above is the operating principle of a transistor.

In the prior art in regard to the present invention, for more efficiently executing the write operation explained above, the high concentration region 17 of the same conductivity type (P type) as the substrate 10 is formed on the substrate 10 between the source region 11 and drain region 12. Formation of this high concentration region 17 narrows the depletion layer existing in the channel near the drain region at the time of write operation. The electrical field in the depletion layer is therefore intensified, and as a result the energy of carrier accelerated in the depletion layer becomes high, also making high the probability of hot carrier generation. As a result, the efficiency of injection of hot carrier into the floating gate 13 is improved. This means that the improved write operation lowers the write voltage.

However, the read-out operation efficiency is reduced when the high concentration region 17 is provided. Since the channel concentration becomes high, the threshold voltage becomes high and the conductance gm of the transistor becomes small. Hence a high power supply voltage is required in order to increase the read-out voltage to be applied to the control gate 15. Moreover, when the read-out voltage is lowered, the difference between the threshold voltage when no electrons are injected into the floating gate 13 and the read-out voltage becomes small, slowing the read-out operation. Alternatively, the channel of the transistor could be widened to increase the conductance gm, but this results in extension of the area occupied by the transistor, thus decreasing the integration density. An attempt to obtain a high concentration channel is equivalent to setting an inconvenient condition for a highly efficient read-out operation.

In FR—A—2 392 468 there is described a semiconductor memory device comprising a charge injection transistor (programming transistor) and a read-out transistor, each having a source region, drain region, a floating gate and a control gate, the source regions of the transistor being connected in common to a power supply, and the floating gates being interconnected.

In IBM Technical Disclosure Bulletin, Vol. 14, No. 12, May 1972, page 3721, there is described a FAMOS device wherein the write voltage is reduced by locally providing a highly doped region under the floating gate.

It is an object of the present invention to provide a semiconductor memory device having a double gate type field effect transistor and ensuring high write and read-out efficiency.

It is another object of the present invention to provide a semiconductor memory device having a double gate type field effect transistor with low write and read-out voltages.

It is a further object of the present invention to provide a semiconductor memory device having a double gate type field effect transistor which can inject the hot carrier generated in the channel into the floating gate with high efficiency.

It is a still further object of the present invention to provide a semiconductor memory device having a double gate type field effect transistor which assures a low threshold voltage and large conductance gm in the read-out operation.

A semiconductor memory device according to the invention comprises a charge injection transistor and read transistor each comprising a source region and drain region having a conductivity type opposite to that of a semiconductor substrate in which they are provided, a conductive floating gate between the respective source and drain regions, and a control gate which is insulated from the corresponding floating gate via an insulating layer, the floating gates of both the transistors being electrically connected, the device being characterized in that the control gates of the transistors are connected in common to a first signal line (bit line), said drain regions are respectively connected to different second and third signal lines (word lines), said source regions are connected in common to a potential, and the impurity concentration of the substrate portion between the source and drain regions of the charge injection transistor is higher than that of the read transistor.

In the accompanying drawings,

Figure 1 is a sectional view showing the structure of a conventional double gate type field effect transistor.

Figure 2 is a schematic diagram of a memory cell having a double gate type field effect transistor according to an embodiment of the present invention.

Figure 3 is an outline sectional view showing the structure of the memory cell of Fig. 2.

Figure 4 and Figure 5 are sectional views on the lines A—A' and B—B' in Fig. 3.

Figure 6 is an outline schematic diagram showing the whole of a semiconductor memory device according to an embodiment of the present invention.

Figure 7 is an outline plan view showing the structure of a memory cell shown in Fig. 6.

Figure 8 is an outline schematic diagram of an analogue invertor according to another embodiment of the present invention.

In the present invention, a memory cell comprises one transistor solely for charge injection and one solely for read-out, so that it can satisfy the conditions of write operation by injecting charges and of read-out operation opposing to it.

Figure 2 is a schematic diagram related to an embodiment of the present invention.

The floating gates 23W, 23R of the injection-only transistor $T_{rw}$ and the read-only transistor $T_{rR}$ are electrically connected. Therefore, when charge is injected to the floating gate 23W from the transistor $T_{rw}$, it is also injected to the floating gate 23R of the transistor $T_{rR}$. The control gate 25W of the transistor $T_{rw}$ and the control gate 25R of the transistor $T_{rR}$ are connected in common to the 1st signal line 25, the drain of the transistor $T_{rw}$ is connected to the 2nd signal line 26, and the drain of the transistor $T_{rR}$ to the 3rd signal line 27, and the sources of both transistors $T_{rw}$, $T_{rR}$ are connected in common.

Figure 3 is an outline plan view showing the structure of a memory cell shown in Fig. 2. The transistors $T_{rw}$, $T_{rR}$ have a common floating gate 23. In addition, a control gate is formed with a 1st signal line 25. 22W, 22R are drain regions and 21W, 21R are source regions which are composed of common diffused layers.

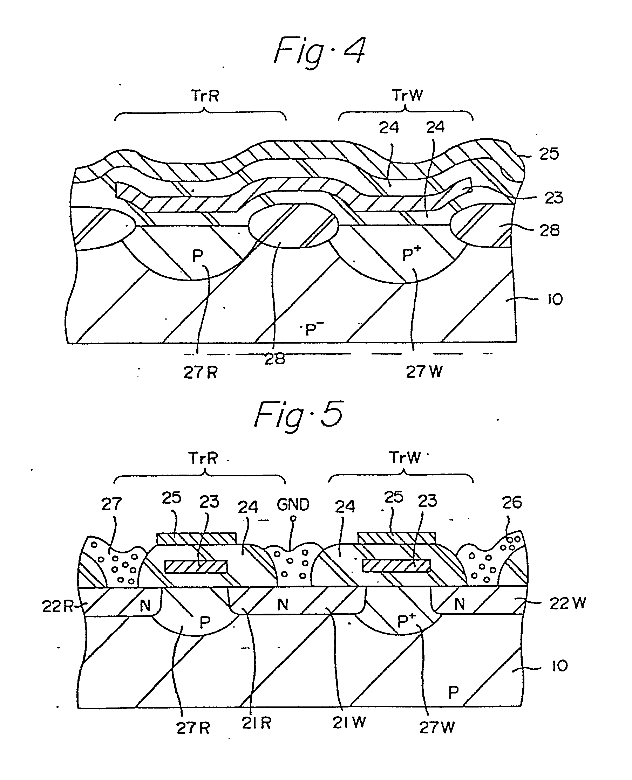

Figure 4 and Figure 5 show the sectional view along the line A—A' of Fig. 3 and the sectional view along the line B—B'. The reference numerals are the same as those in Fig. 3. In these Figures, 24, 28 are insulating layers. The 1st signal line 25 and the floating gate 23 are composed of, for example, poly-crystalline silicon layers, while the insulating layers 24, 28 are composed of, for example, silicon oxide layers.

In this embodiment, the semiconductor substrate 10, consisting of silicon, has P type conductivity, whle the source regions 21R, 21W and the drain regions 22W, 22R have N type conductivity.

Each part of the injection-only transistor $T_{rw}$ and the read-only transistor $T_{rR}$ is designed respectively under the optimum condition. For example, in the channel regions of both transistors $T_{rw}$, $T_{rR}$, the high concentration regions 27W, 27R have higher P type impurity concentrations that the substrate 10, and the concentration in the region 27W is high and that in the region 27R is lower than the concentration in the region 27W.

The operation of this embodiment as a memory cell is explained hereunder.

(a) Write operation by charge injection:

The injection-only transistor $T_{rw}$ is used. The substrate 10 and the source 21W are grounded and a positive high voltage is applied to the 1st signal line 25 and the 2nd signal line 26. Since a high impurity concentration region 27W is provided in the channel of transistor $T_{rw}$, the probability of generating hot carriers is high and the write efficiency is very good. Particularly since the transistor $T_{rw}$ is not required to satisfy the design condition required for the read-out operation as opoosed to the design condition for the write efficiency, the efficiency of charge injection in the

transistor $\overline{T_{rW}}$ is excellent as compared with the prior art as mentioned above. Therefore, the write operation is carried out at a high speed. Moreover, even when the voltage to be applied to the 2nd signal line is lowered, a charge injection efficiency equal to the conventional one is obtained. Therefore, the write voltage can be lowered. In this embodiment the charges injected are electrons, while holes are injected when the conductivity types of the substrate and of the source/drain regions are reversed. In this case, the abovementioned effect can also be obtained.

(b) Read-out operation:

The read-only transistor $\overline{T_{rR}}$ is used. First, the substrate 10 and the source 21R are grounded and the specified read-out operation is applied to the 1st signal line 25. This read-out voltage is an intermediate voltage between the threshold voltage when the charges are stored in the floating gate 23 and that when they are not stored. Thus, the stored in formation can be read by detecting a difference of degree of conductivities of transistor $\overline{T_{rR}}$ due to the existence or non-existence of the injected charges of the floating gate 23, through detection of a voltage or current on the 3rd signal line 27 at that time. The impurity concentration of the high concentration region 27R of channel of the transistor or $\overline{T_{rR}}$ is lower than that of the region 27W and is also lower than that of the high concentration region 17 of the conventional transistor explained above. Therefore, the threshold voltage becomes lower and the conductance gm becomes higher. For this reason, the write voltage can be lowered. Moreover, since a difference between the threshold voltage when no electrons are injected and the read-out voltage is larger than that of the prior art even when the read-out voltage is sufficiently low, a high-speed read-out operation can be realized.

As explained above, the write operation and read-out operation are performed efficiently.

There are other advantages for the transistors $\overline{T_{rW}}$, $\overline{T_{rR}}$ in addition to the abovementioned impurity concentration of the high concentration regions 27W, 27R provided at the channel. The transistor $\overline{T_{rW}}$ is not required to have a large condcutance gm. As a result there is no need to widen the channel width in order to increase the conductance gm, unlike the conventional transistor. Therefore, the area occupied by the transistor $\overline{T_{rW}}$ can be reduced as compared with the conventional one. In addition, since the transistor $\overline{T_{rR}}$ has sufficiently low threshold voltage and sufficiently high conductance gm, there is no need to widen the channel, as in the conventional transistor. As a result, the area occupied by the transistor $\overline{T_{rR}}$ can also be reduced as compared with the conventional one.

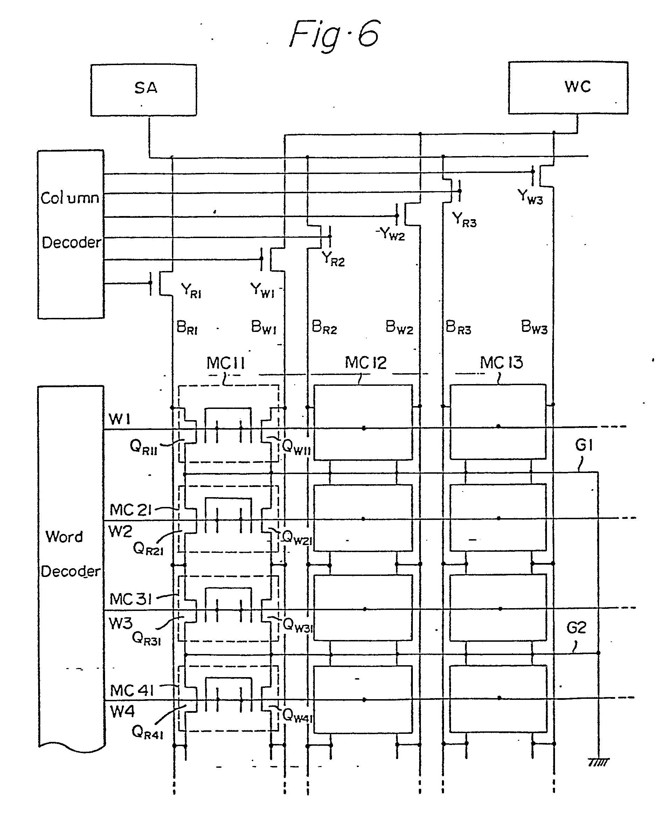

Figure 6 is an outline schematic diagram showing the whole of the semiconductor memory device of an embodiment of the present invention. In this embodiment, the memory cells MC11, MC12 . . . . . respectively have the same structure as Figs. 3, 4, 5 described above. As the 1st signal lines, the word lines $W_1$, $W_2$ . . . . . are used, while as the 2nd signal lines, the charge injection bit lines $B_{w1}$, $B_{w2}$ . . . . . and as the 3rd signal lines, the read-out bit lines $B_{R1}$, $B_{R2}$ . . . . . respectively, and these signal lines are connected to the transistors $Q_{w11}$, $Q_{R11}$ . . . . . of the memory cells MC11, MC12 . . . . . G1, G2 are grounded common source regions. The transistors $Y_{w1}$, $Y_{w2}$, . . . . . connect, in accordance with the signal of a column decoder, the charge injection bit lines $B_{w1}$, $B_{w2}$ . . . . . being connected to the charge injection transistors $Q_{w11}$, $Q_{w12}$ . . . . . of the selected memory cells with charge injection circuit WC. The transistors $Y_{R1}$, $Y_{R2}$ . . . . . also connect the read-out bit lines $B_{R1}$, $B_{R2}$ . . . . . being connected to the read-out transistors $Q_{R11}$, $Q_{R12}$ . . . . . with the sense amplifier SA.

The write operation and read operation by the charge injection of the memory cells MC11, MC12 . . . . . are similar to those explained previously.

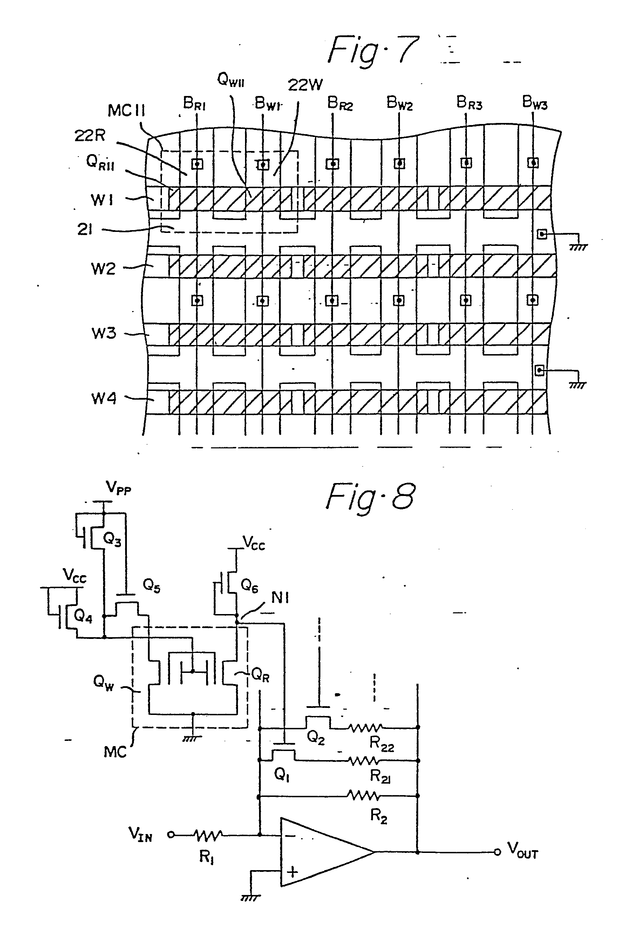

Figure 7 is an outline plan view indicating the structure of the schematic diagram of Fig. 6. The word lines $W_1$, $W_2$ . . . . . are arranged in parallel to the groove direction, and the hatched portion indicates the floating gate of memory cells formed by the polycrystalline silicon layer. The portion enclosed by the broken line indicates the area of a single memory cell MC11. 22W is the drain region of transistor $Q_{w11}$, 22R is the drain region of transistor $Q_{R11}$, 21 is the common source region, and 22W, 22R and 21 are all composed of the impurity diffused regions provided on the substrate. The drain regions 22W and 22R are respectively connected to the bit lines $B_{w1}$, $B_{R1}$, while the bit lines $B_{w1}$, $B_{R1}$ . . . . . are formed, for example, by the A1 layer provided on the word lines $W_1$, $W_2$ . . . . . In addition, the common source region 21 is grounded.

Figure 8 is an analogue invertor circuit forming another embodiment of the present invention. The analogue inverter circuit receives an input of $V_{IN}$ and provides an output of inverted polarity $V_{OUT} = -V_{IN}$. For this purpose the resistances $R_1$, $R_2$ must be formed in such a way that they are accurately equal ($R_1 = R_2$). However, in practice, it is very difficult to make $R_1 = R_2$, due to errors in the production processes. In the present embodiment, therefore, compensating resistors $R_{21}$, $R_{22}$, . . . . . are prepared in parallel to the resistor $R_2$ and the compensating transistors $Q_1$, $Q_2$ . . . . . are turned ON in accordance with the results of tests after completion, thus connecting the resistors $R_{21}$, $R_{22}$, . . . . . in parallel to the resistor $R_2$. Thereby, $R_1 = R_2'$ ($R_2'$ is determined by $R_1$ and $R_{21}$, $R_{22}$ . . . . . ) can be accurately realized despite an error in the production processes.

In the present embodiment, the said compensating transistors $Q_1$, $Q_2$ . . . . . are turned ON through injection of charges (electrons) into the floating gate of transistors $Q_R$ and $Q_W$ of the memory cells MC. The memory cell MC has almost the same structure as the aforementioned embodiment. The charges are injected by the transistor $Q_W$ through application of a high voltage to the test terminal $V_{pp}$. As a result the transistor $Q_R$ is turned OFF, setting the terminal N1 to a high voltage level, and turning ON the transistor $Q_1$. If no charge is injected, the transistor $Q_R$ is turned ON, setting the terminal N1 to a low voltage level, and turning OFF the transistor $Q_1$. This process is also applied to the transistors $Q_2, \ldots$

In the case of this embodiment, the transistors $Q_R$, $Q_W$ of the memory cell MC can be formed by almost the same process as other devices having double poly-crystalline silicon layers, except only for providing the high impurity region in the channel. Therefore, as in the case of this embodiment, even when the memory cell MC is provided within the ordinary circuit other than the memory device, such as analogue circuit, hardly any change in the production process is required. Moreover, since the charge injection voltage can be lowered and the read-out voltage can also be lowered, efficiency is far improved compared with the case where the memory cell having the conventional structure is used.

As explained previously, the invention provides a double gate type field effect transistor which has improved the write efficiency and read-out efficiency by charge injection, and it, as a semiconductor memory device, can be used effectively as the compensating switching circuit in the ordinary circuit such as the analogue invertor, etc.

## Claims

1. A semiconductor memory device comprising a charge injection transistor $\overline{T_{rw}}$ and read transistor $\overline{T_{rR}}$ each comprising a source region (21W, 21R) and drain region (22W, 22R) having a conductivity type opposite to that of a semiconductor substrate (10) in which they are provided, a conductive floating gate (23) between the respective source and drain regions, and a control gate (25) which is insulated from the corresponding floating gate via an insulating layer (24), the floating gates of both the transistors being electrically connected, the device being characterized in that the control gates (25) of the transistors are connected in common to a first signal line (25), said drain regions are respectively connected to different second and third signal lines (26, 27), said source regions are connected in common to a potential, and the impurity concentration of the substrate portion between the source and drain regions (21W, 22W) of the charge injection transistor is higher than that of the read transistor.

2. A semiconductor memory device as claimed in claim 1 arranged so that the charge can be applied to the floating gate of said charge injection transistor ($\overline{T_{rW}}$) by applying a specified voltage to said first signal line (25) and a specified write voltage to the second signal line (26), and the stored information can be read by applying a specified read voltage to said first signal line and detecting the conductance of said read transistor ($\overline{T_{rR}}$) via the said third signal line (27).

3. A semiconductor memory device as claimed in claim 1, wherein the source regions (21W, 21R) of said charge injection transistor and of said read transistor are composed of a common impurity diffused region, said floating gates are composed of a first common conductive layer and said control gates are composed of a second common conductive layer.

4. A semiconductor memory device as claimed in claim 3 wherein said first and second conductive layers are composed of poly-crystalline slicon.

5. A semiconductor memory device as claimed in any preceding claim wherein memory cells, each having one said charge injection transistor and one said read transistor, are arranged in the form of a matrix, said first signal line is composed of word lines ($W_1$, $W_2 \ldots$) arranged in the row direction, said second signal line is composed of charge injection bit lines ($B_{w1}$, $B_{w2} \ldots$) arranged in the column direction and said third signal line is composed of read-out bit lines ($B_{R1}$, $B_{R2} \ldots$) arranged in the column direction.

6. A semiconductor memory device as claimed in claim 5, wherein said word lines are composed of a polycrystalline silicon layer, a part of said word lines is used as said control gates, and said read-out bit lines are composed of metal conductors.

7. A semiconductor memory device as claimed in claim 5, which includes a column decoder circuit which, during the charge injection, connects the selected said charge injection bit lines with said charge injection circuit which generates the write voltage, and also, at the time of read-out operation, connects selected said read-out bit lines with a sense circuit which detects the conductance of said read transistor, and a word decoder circuit which applies the specified voltage to the selected word lines.

8. A semiconductor memory device as claimed in any one of claims 1 to 4, which also includes a switching element ($Q_1$, $Q_2 \ldots$) connected to a second potential via the drain load of said read transistor, said switching element being arranged to be turned ON and OFF by means of a difference in the potential levels of said load due to a difference in conductance of said read transistor.

9. An analogue inverter incorporating a semiconductor memory device as claimed in claim 8, wherein a compensating resistance ($R_{21}$, $R_{22} \ldots$) is provided via said switching element ($Q_1$, $Q_2 \ldots$) to one or both of a first resistor ($R_1$) provided at the input portion of the analogue invertor circuit which outputs a signal reversed in polarity from an input signal and a second resistor ($R_2$) provided in a feed-back loop from the output portion to the input portion, the resistance of said 1st or second resistor being compensated by injecting charges to the specified said floating gate in accordance with test results, thereby changing the ON—OFF condition of said switching element.

**Patentansprüche**

1. Halbleiterspeichervorrichtung mit einem Ladungsinjektionstransistor ($T_{rW}$) und einem Lesetransistor ($T_{rR}$), die jeweils einen Sourcebereich (21W, 21R) und einen Drainbereich (22W, 22R) von einem Leitfähigkeitstyp, der entgegengesetzt zu demjenigen des Halbleitersubstrats (10) ist, in welchem sie vorgesehen sind, ein leitendes, schwimmendes Gate (23) zwischen entsprechenden Source- und Drainbereichen, und ein Steuergate (25), welches von dem entsprechenden schwimmenden Gate über eine isolierende Schicht (24) isoliert ist, haben, wobei die schwimmenden Gates von beiden Transistoren elektrisch verbunden sind, dadurch gekennzeichnet, daß die Steuergates (25) der Transistoren gemeinsam mit einer ersten Signalleitung (25) verbunden sind, die genannten Drainbereiche jeweils mit verschiedenen zweiten und dritten Signalleitungen (26, 27) verbunden sind, die Sourcebereiche gemeinsam mit einem Potential verbunden sind und die Verunreinigungskonzentration des Substratabschnitts zwischen den Source- und Drainbereichen (21W, 22W) des Ladungsinjektionstransistors höher als diejenige des Lesetransistors ist.

2. Halbleiterspeichervorrichtung nach Anspruch 1, welche so angeordnet ist, daß die Ladung dem schwimmenden Gate des genannten Ladungsinjektionstransistors ($T_{rW}$) durch Zuführung einer spezifizierten Spannung zu der ersten Signalleitung (25) und einer spezifizierten Schreibspannung zu der zweiten Signalleitung (26) zugeführt wird, und die gespeicherte Information durch Zuführung einer spezifizierten Lesespannung zu der ersten Signalleitung und durch Bestimmung der Konduktanz des genannten Lesetransistors ($T_{rR}$) über die genannte dritte Signalleitung (27) gelesen werden kann.

3. Halbleiterspeichervorrichtung nach Anspruch 1, bei welcher die Sourcebereiche (21W, 21R) des genannten Ladungsinjektionstransistors und des genannten Lesetransistors aus einem gemeinsamen Verunreinigungsdiffusionsbereich bestehen, die genannten schwimmenden Gates aus einer ersten gemeinsamen leitenden Schicht bestehen und die genannten Steuergates aus einer zweiten gemeinsamen leitenden Schicht bestehen.

4. Halbleiterspeichervorrichtung nach Anspruch 3, bei welcher die genannten ersten und zweiten leitenden Schichten aus polykristallinem Silizium bestehen.

5. Halbleiterspeichervorrichtung nach einem der vorhergehenden Ansprüche, bei welcher Speicherzellen, die jeweils einen genannten Ladungsinjektionstransistor und einen genannten Lesetransistor umfassen, in Form einer Matrix angeordnet sind, die genannte erste Signalleitung aus Wortleitungen ($W_1$, $W_2$.....) besteht, die in der Reihenrichtung angeordnet sind, die genannte zweite Signalleitung aus Ladungsinjektionsbitleitungen ($B_{w1}$, $B_{w2}$.....) besteht, die in der Spaltenrichtung angeordnet sind, und die genannte dritte Signalleitung aus Auslese-Bitleitungen ($B_{R1}$, $B_{R2}$.....) besteht, die in der Spaltenrichtung angeordnet sind.

6. Halbleiterspeichervorrichtung nach Anspruch 5, bei welcher die genannten Wortleitungen aus einer polykristallinen Siliziumschicht bestehen, ein Teil der genannten Wortleitungen als die genannten Steuergates verwendet wird und die Auslese-Bitleitungen aus Metalleitern bestehen.

7. Halbleiterspeichervorrichtung nach Anspruch 5, welche eine Spaltendecoderschaltung umfaßt, die, während der Ladungsinjektion, die ausgewählten Ladungsinjektionsbitleitungen mit der genannten Ladungsinjektionsschaltung, welche die Schreibspannung erzeugt, verbindet, und auch, zur Zeit des Auslesebetriebs, die genannten ausgewählten Auslese-Bitleitungen mit einer Leseschaltung verbindet, welche die Konduktanz des genannten Lesetransistors feststellt, und eine Wortdecoderschaltung, welche die spezifizierte Spannung den ausgewählten Wortleitungen zuführt.

8. Halbleiterspeichervorrichtung nach einem der Ansprüche 1 bis 4, welche ferner ein Schaltelement ($Q_1$, $Q_2$.....) umfaßt, das mit einem zweiten Potential über eine Drainlast des genannten Lese- transistors verbunden ist, wobei das genannte Schalt- element so angeordnet ist, daß es mittels einer Differenz in den Potentialpegeln der genannten Last aufgrund einer Differenz der Konduktanz des genannten Lesetransistors EIN und AUS geschaltet wird.

9. Analoginverter, mit einer Halbleiterspeichervorrichtung nach Anspruch 8, bei welchem ein kompensierender Widerstand ($R_{21}$, $R_{22}$.....) über das genannte Schaltelement ($Q_1$, $Q_2$.....) für einen oder beide von einem ersten Widerstand ($R_1$) der an dem Eingangsabschnitt der Analoginverterschaltung vorgesehen ist, welche ein Signal abgibt, dessen Polarität umgekehrt zu dem Eingangssignal ist, und einem zweiten Widerstand ($R_2$) vorgesehen ist, der in einer Rückkopplungsschleife von dem Ausgangsabschnitt zu dem Eingangsabschnitt vorgesehen ist, wobei der Widerstand des genannten ersten oder zweiten Widerstandes durch Injektion von Ladungen zu dem spezifizierten genannten schwimmenden Gater in Übereinstimmung mit Testergebnissen kompensiert wird, wodurch der EIN-AUS-Zustand des genannten Schaltelements geändert wird.

**Revendications**

1. Dispositif de mémoire à semiconducteur comprenant un transistor à injection de charges ($T_{rW}$) et un transistor de lecture ($T_{rR}$) comprenant chacun une région de source (21W, 21R) et une région de drain (22W, 22R) ayant un type de conductivé opposé à celui d'un substrat semiconducteur (10) dans lequel elles sont prévues, une grille flottante conductrice (23) entre les régions de source et de drain respectives, et une grille de contrôle (25) qui est isolée de la grille flottante correspondante par une couche isolante (24), les grilles flottantes des deux transistors étant connectées électriquement, le dispositif étant caractérisé en ce que les grilles de contrôle (25) des transistors sont connectées en commun à un premier fil de signal (25), les régions de drain sont respectivement connectées à des deuxième et troisième fils de signal différents (26, 27), les régions de source sont connectées en commun à une borne de tension, et en ce que la concentration en impuretés de la partie de substrat située entre les régions de source et de drain (21W, 22W) du transistor à injection de charges est supérieure à cele du transistor de lecture.

2. Dispositif de mémoire à semiconducteur selon la revendication 1, agencé de telle sorte que les charges peuvent être appliquées à la grille flottante du transistor à injection de charges ($\overline{T_{rW}}$) en appliquant une tension spécifiée au premier fil de signal (25) et une tension d'écriture spécifiée au deuxième fil de signal (26), et l'information mémorisée peut être lue en appliquant une tension de lecture spécifiée au premier fil de signal et en détectant la conductance du transistor de lecture ($\overline{T_{rR}}$) par l'intermédiaire du troisième fil de signal ($\overline{27}$).

3. Dispositif de mémoire à semiconducteur selon la revendication 1, dans lequel les régions de source (21W, 21E) du transistor à injection de charges et du transistor de lecture sont constituées d'une région commune à diffusion d'impuretés, les grilles flottantes sont constituées d'une première couche conductrice commune et les grilles de contrôle sont constituées d'une seconde couche conductrice commune.

4. Dispositif de mémoire à semiconducteur selon la revendication 3, dans lequel les première et seconde couches conductrices sont constituées de silicium polycristallin.

5. Dispositif de mémoire à semiconducteur selon l'une quelconque des revendications 1 à 4, dans lequel des cellules de mémoire, comportant chacune undit transistor à injection de charges et undit transistor de lecture, sont disposées sous la forme d'une matrice, le premier fil de signal est constitué de fils de mot ($W_1, W_2$ ..... ) disposés dans la direction des lignes, le deuxième fil de signal est constitué de fils de bit d'injection de charge ($B_{W1}, B_{W2}$ ..... ) disposés dans la direction des colonnes et le troisième fil de signal est constitué de fils de bit de lecture ($B_{R1}, B_{R2}$ ..... ) disposés dans la direction des colonnes.

6. Dispositif de mémoire à semiconducteur selon la revendication 5, dans lequel les fils de mot sont constitués d'une couche de silicium polycrystallin, une partie des fils de mot est utilisée comme lesdites grilles de contrôle, et les fils de bit d'injection de charges et les fils de bit de lecture sont constitués de conducteurs métalliques.

7. Dispositif de mémoire à semiconducteur selon la revendication 5, qui comprend un circuit décodeur de colonne qui, pendant l'injection de charges, relie les fils de bit d'injection de charges sélectionnés au circuit d'injection de charges qui engendre la tension d'écriture, et également, au moment d'une opération de lecture, relie les fils de bit de lecture sélectionnés à un circuit de détection qui détecte la conductance du transistor de lecture, et un circuit décodeur de mot qui applique la tension spécifiée aux fils de mot sélectionnés.

8. Dispositif de mémoire à semiconducteur selon l'une quelconque des revendications 1 à 4, qui comprend également un élément de commutation ($Q_1, Q_2$ ..... ) connecté à seconde borne de tension par la charge de drain du transistor de lecture, l'élément de commutation étant agencé pour être rendu conducteur et mis à l'état bloqué au moyen d'une différence des niveaux de tension de la charge due à une différence de conductance du transistor de lecture.

9. Inverseur analogique incorporant un dispositif de mémoire à semiconducteur selon la revendication 8, dans lequel une résistance de compensation ($R_{21}, R_{22}$ ..... ) est fournie par l'élément de commutation ($Q_1, Q_2$ ..... ) à une ou à deux d'une première résistance ($R_1$) prévue dans la patie d'entrée du circuit inverseur analogique qui engendre en sortie un signal de polarité inversée à partir d'un signal d'entrée et d'une seconde résistance ($R_2$) prévue dans une boucle de réaction de la partie de sortie à la partie d'entrée, la résistance de la première ou de la seconde résistance étant compensée par l'injecton de charges dans la grille flottante spécifiée conformément aux résultats de test, ce qui change l'état conducteurbloqué de l'élément de commutation.

## Fig·1

## Fig·2

## Fig·3

## Fig·4

## Fig·5

# Fig·6

## Fig·7

## Fig·8